# EUROPEAN PATENT SPECIFICATION

(11) **EP 1 190 305 B1**
(45) Date of publication and mention of the grant of the patent: **08.10.2003**
(21) Application number: 00932414.6
(22) Date of filing: 12.05.2000
(51) Int. Cl.: G06F 9/00

(54) **METHOD AND APPARATUS FOR JUMP DELAY SLOT CONTROL IN A PIPELINED PROCESSOR**
VERFAHREN UND VORRICHTUNG ZUM STEUERN EINES SPRUNGVERZÖGERUNGSSCHLITZES IN EINEM PIPELINEPROZESSOR
PROCEDE ET APPAREIL DE CONTROLE D'EMPLACEMENT DE TEMPORISATION DE BRANCHEMENT DANS UN PROCESSEUR PIPELINE

(30) Priority: 13.05.1999 US 134253 P; 14.10.1999 US 418663; 13.03.2000 US 523877
(43) Date of publication of application: 27.03.2002
(73) Proprietor: ARC International U.S. Holdings Inc., San Jose, CA 95119 (US)
(72) Inventor: WARNES, Peter, East Ham, Greater London E6 1AR (GB); GRAHAM, Carl, North Chingford, Greater London E4 7ET (GB)
(74) Representative: Popp, Eugen, Dr.
(86) International application number: US0013233
(87) International publication number: WO00070447

(56) References cited:
- EP-A- 0 355 069
- EP-A- 0 476 628
- US-A- 5 724 566
- PATEL P ET AL: "ARCHITECTURAL FEATURES OF THE I860(TM) - MICROPROCESSOR RISC CORE AND ON-CHIP CACHES" PROCEEDINGS OF THE INTERNATIONAL CONFERENCE ON COMPUTER DESIGN: VLSI IN COMPUTERS AND PROCESSORS. (ICCD),US,WASHINGTON, IEEE COMP. SOC. PRESS, vol. -, 1989, pages 385-390, XP000090507 ISBN: 0-8186-1971-6

## Description

This application claims priority to U.S. Provisional Patent Application Serial No. 60/134,253 filed May 13, 1999, entitled "Method And Apparatus For Synthesizing And Implementing Integrated Circuit Designs," and to co-pending U.S. Patent Application No. 09/418,663 filed October 14, 1999, entitled "Method And Apparatus For Managing The Configuration And Functionality Of A Semiconductor Design," which claims priority to U.S. Provisional Patent Application Serial No. 60/104,271 filed October 14, 1998, of the same title.

### Background of the Invention

### 1. Field of the Invention

The present invention relates to the field of integrated circuit design, specifically to the use of a hardware description language (HDL) for implementing instructions in a pipelined central processing unit (CPU) or user-customizable microprocessor.

### 2. Description of Related Technology

RISC (or reduced instruction set computer) processors are well known in the computing arts. RISC processors generally have the fundamental characteristic of utilizing a substantially reduced instruction set as compared to non-RISC (commonly known as "CISC") processors. Typically, RISC processor machine instructions are not all micro-coded, but rather may be executed immediately without decoding, thereby affording significant economies in terms of processing speed. This "streamlined" instruction handling capability furthermore allows greater simplicity in the design of the processor (as compared to non-RISC devices), thereby allowing smaller silicon and reduced cost of fabrication.

RISC processors are also typically characterized by (i) load/store memory architecture (i.e., only the load and store instructions have access to memory; other instructions operate via internal registers within the processor); (ii) unity of processor and compiler; and (iii) pipelining.

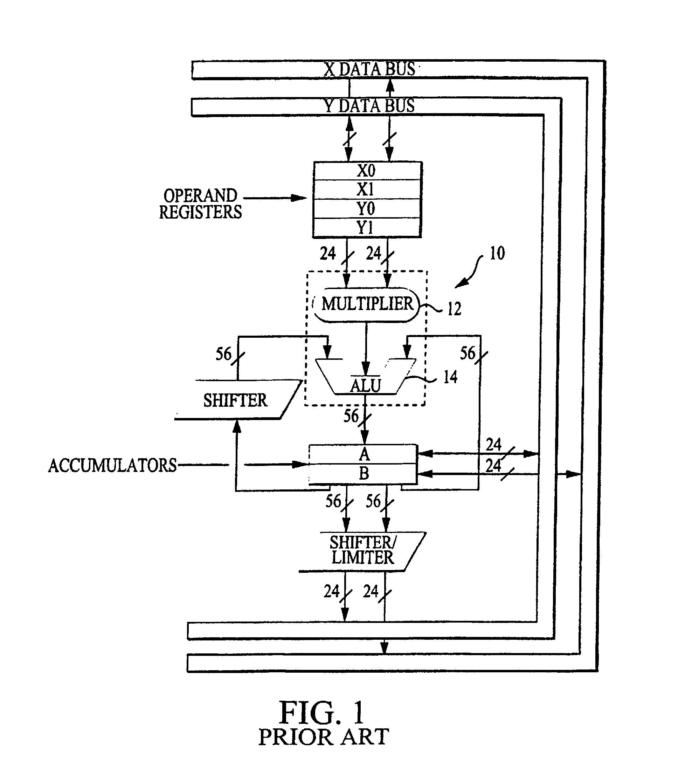

Pipelining is a technique for increasing the performance of processor by dividing the sequence of operations within the processor into segments which are effectively executed in parallel when possible. In the typical pipelined processor, the arithmetic units associated with processor arithmetic operations (such as ADD, MULTIPLY, DIVIDE, etc.) are usually "segmented", so that a specific portion of the operation is performed in a given segment of the unit during any clock cycle. Fig. 1 illustrates a typical processor architecture having such segmented arithmetic units. Hence, these units can operate on the results of a different calculation at any given clock cycle. As an example, in the first clock cycle two numbers A and B are fed to the multiplier unit 10 and partially processed by the first segment 12 of the unit. In the second clock cycle, the partial results from multiplying A and B are passed to the second segment 14 while the first segment 12 receives two new numbers (say C and D) to start processing. The net result is that after an initial startup period, one multiplication operation is performed by the arithmetic unit 10 every clock cycle.

The depth of the pipeline may vary from one architecture to another. In the present context, the term "depth" refers to the number of discrete stages present in the pipeline. In general, a pipeline with more stages executes programs faster but may be more difficult to program if the pipeline effects are visible to the programmer. Most pipelined processors are either three stage (instruction fetch, decode, and execute) or four stages (such as instruction fetch, decode, operand fetch, and execute, or alternatively instruction fetch, decode/operand fetch, execute, and writeback), although more or less stages may be used.

Interlocks are necessary with pipelined architectures generally to address, inter alia, the case where a following instruction (n +1) in an earlier pipeline stage needs the result of the instruction n from a later stage. A simple solution to the aforementioned problem is to delay the operand calculation in the instruction decoding phase by one or more clock cycles. "Scoreboarding" may be used, wherein a bit is attached to each processor register to act as an indicator of the register content. Alternatively, NOPs (no-operation opcodes) may be inserted in the code so as to delay the appropriate pipeline stage when desired. This later approach has been referred to as "software interlocking" and has the disadvantage of increasing the code size and complexity of programs that employ instructions that require interlocking.

Another important consideration in processor design is program branching or "jumps". All processors support some type of branching instructions. Simply stated, branching refers to the condition where program flow is interrupted or altered. Other operations such as loop setup and subroutine call instructions also interrupt or alter program flow in a similar fashion. The term "jump delay slot" is often used to refer to the slot within a pipeline subsequent to a branching or jump instruction being decoded. Branching may be conditional (i.e., based on the truth or value of one or more parameters) or unconditional. It may also be absolute (e.g., based on an absolute memory address), or relative (e.g., based on relative addresses and independent of any particular memory address).

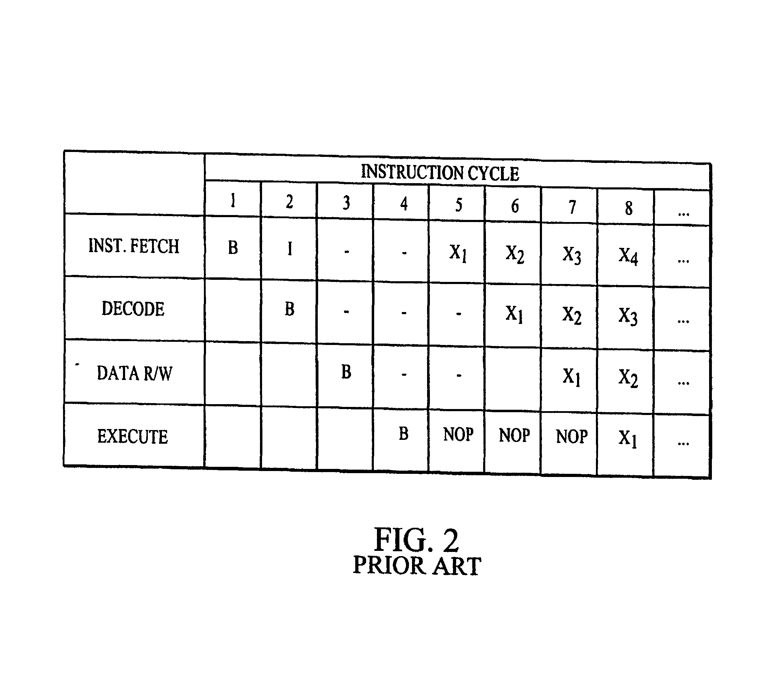

Branching can have a profound effect on pipelined systems. By the time a branch instruction is inserted and decoded by the processor's instruction decode stage (indicating that the processor must begin executing a different address), the next instruction word in the instruction sequence has been fetched and inserted into the pipeline. One solution to this problem is to purge the fetched instruction word and halt or stall further fetch operations until the branch instruction has been executed, as illustrated in Fig. 2. This approach, however, by necessity results in the execution of the branch instruction in several instruction cycles, this number typically being between one and the depth of the pipeline employed in the processor design. This result is deleterious to processor speed and efficiency, since other operations can not be conducted by the processor during this period. Alternatively, a delayed branch approach may be employed. In this approach, the pipeline is not purged when a branch instruction reaches the decode stage, but rather subsequent instructions present in the earlier stages of the pipeline are executed normally before the branch is executed. Hence, the branch appears to be delayed by the number of instruction cycles necessary to execute all subsequent instructions in the pipeline at the time the branch instruction is decoded. This approach increases the efficiency of the pipeline as compared to multi-cycle branching described above, yet also complexity (and ease of understanding by the programmer) of the underlying code.

Digital processor architectures incorporating methods for controlling the execution of branching instructions within the processor pipeline are well known; see, *e*.*g*., P. Patel, et al., "Architectural Features of the I860™ - Microprocessor RISC Core and On-chip Caches", Proceedings of the 1989 IEEE International Conference on Computer Design: VLSI in Computers and Processors, ICCD '89, IEEE Comp. Society Press, pp. 389-390, which describes a processor architecture which utilizes a "squash bit" in the conditional branch instructions. When the squash bit is set, the instruction in the delay slot is killed for branch-taken cases, and executed for branch-not-taken cases. Alternatively, when the squash bit is not set, the instruction in the delay slot is killed for branch-not-taken cases, and executed for branch-taken cases. The squash bit is determined by predicting the branch direction at program compilation time. See also U.S. Patent No. 5,724,566, issued March 3, 1998 and assigned to Texas Instruments Inc., which discloses the use of an "address pipeline" which holds the addresses of the instructions present in the instruction pipeline, and facilitates, inter alia, stopping of the data processor during a branch delay slot without loss of the branch information.

Based on the foregoing, processor designers and programmers must carefully weigh the tradeoffs associated with utilizing either the delayed or multi-cycle branching approaches of the prior art. What is needed is an improved approach to branching/jumping which overcomes or mitigates these tradeoffs while providing the additional flexibility. Furthermore, as more pipeline stages (and even multiple multi-stage pipelines) are added to processor designs, the benefits of improved and simplified branching and instruction execution within the processor increased manifold. Additionally, the ability to readily synthesize such improved pipelined processor designs in an application-specific manner, and using available synthesis tools, is of significant utility to the designer and programmer.

### Summary of the Invention

The present invention satisfies the aforementioned needs by providing an improved method and apparatus for executing instructions within a digital processor architecture.

In a first aspect of the invention, an improved method of managing branching and instruction execution within a pipelined processor is disclosed. In one exemplary embodiment, three discrete delay slot modes are implemented using predetermined bits of the instruction word. These three modes include: (i) execution of a delay slot instruction under all circumstances; (ii) the execution of a delay slot instruction only if a jump is taken, and (iii) a pipeline stall or bubble in place of an instruction execution if a jump is taken. A pipeline bubble is analogous to a NOP no-operation instruction in that it is an instruction which flows through the pipeline without performing any operation. It will typically be an instruction which has been 'killed' after having been fetched into the pipeline. The availability of these three modes provides the programmer with additional flexibility in jump delay slot control using existing branch or similar instructions. Unconstrained and constrained exemplary synthesized logic implementing the aforementioned delay slot method is also disclosed.

### Brief Description of the Drawings

Fig. 1 is block diagram of a typical prior art processor architecture employing "segmented" arithmetic units.
Fig. 2 illustrates graphically the operation of a four stage pipelined processor undergoing a multi-cycle branch operation.
Fig. 3 is a logical flow diagram illustrating the generalized methodology of controlling jump delay slot modes within a pipelined processor according to the present invention.
Fig. 3a is a logical flow diagram illustrating one exemplary embodiment of the method of executing the designated jump delay slot mode of Fig. 3
Fig. 4 is a logical flow diagram illustrating the generalized methodology of synthesizing processor logic which incorporates jump delay slot modes according to the present invention.
Fig. 5 is a schematic diagram illustrating a first embodiment of synthesized logic (unconstrained) used to implement the jump delay slot modes of the present invention.
Fig. 6 is a schematic diagram illustrating a second embodiment of synthesized logic (constrained) used to implement the jump delay slot modes of the present invention.
Fig. 7 is a block diagram of a pipelined processor design incorporating jump delay slot modes according to the present invention.
Fig. 8 is a functional block diagram of one exemplary embodiment of a computer system useful for synthesizing the logic apparatus of Figs. 5-6.

### Detailed Description of the Invention

Reference is now made to the drawings wherein like numerals refer to like parts throughout.

As used herein, the term "processor" is meant to include any integrated circuit or other electronic device capable of performing an operation on at least one instruction word including, without limitation, reduced instruction set core (RISC) processors such as the ARC user-configurable core manufactured by the Assignee hereof, central processing units (CPUs), and digital signal processors (DSPs). The hardware of such devices may be integrated onto a single piece of silicon ("die"), or distributed among two or more die. Furthermore, various functional aspects of the processor may be implemented solely as software or firmware associated with the processor.

Additionally, it will be recognized by those of ordinary skill in the art that the term "stage" as used herein refers to various successive stages within a pipelined processor; i.e., stage 1 refers to the first pipelined stage, stage 2 to the second pipelined stage, and so forth.

It is also noted that while the following description is cast in terms of VHSIC hardware description language (VHDL), other hardware description languages such as Verilog® may be used to describe various embodiments of the invention with equal success. Furthermore, while an exemplary Synopsys® synthesis engine such as the Design Compiler 1999.05 (DC99) is used to synthesize the various embodiments set forth herein, other synthesis engines such as Buildgates® available from, inter alia, Cadence Design Systems, Inc., may be used. IEEE std. 1076.3-1997, IEEE Standard VHDL Synthesis Packages, describe an industry-accepted language for specifying a Hardware Definition Language-based design and the synthesis capabilities that may be expected to be available to one of ordinary skill in the art.

Lastly, it will be recognized that while the following description illustrates specific embodiments of logic synthesized by the Assignee hereof using the aforementioned synthesis engine and VHSIC hardware description language, such specific embodiments being constrained in different ways, these embodiments are only exemplary and illustrative of the design process of the present invention. Furthermore, while a 1.0 um process was specified for these embodiments, other fabrication processes (such as 0.35 um or 0.18 um) may conceivably be used in conjunction with the invention disclosed herein.

### Jump Delay Slot Modes

The improved method of controlling jump delay slots and their encoding within a processor according to the present invention is now described.

The present invention generally comprises a plurality of different "jump modes" or modifiers. These modifiers control the operation of the processor during jumping; specifically, the execution of instructions subsequent to or in an earlier pipeline stage than that of the jump instruction itself. Collectively, these modifiers provide the programmer with benefits not afforded by either the multi-cycle or delayed branch approaches in isolation since the programmer can arrange the program code so that the pipeline operates in the desired fashion during such jump or branching operations.

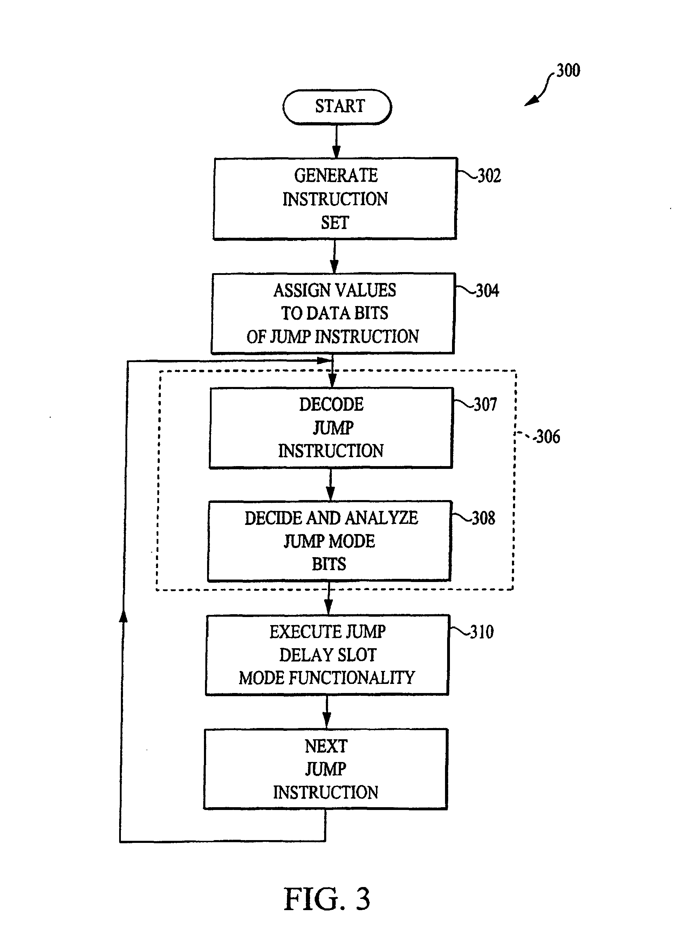

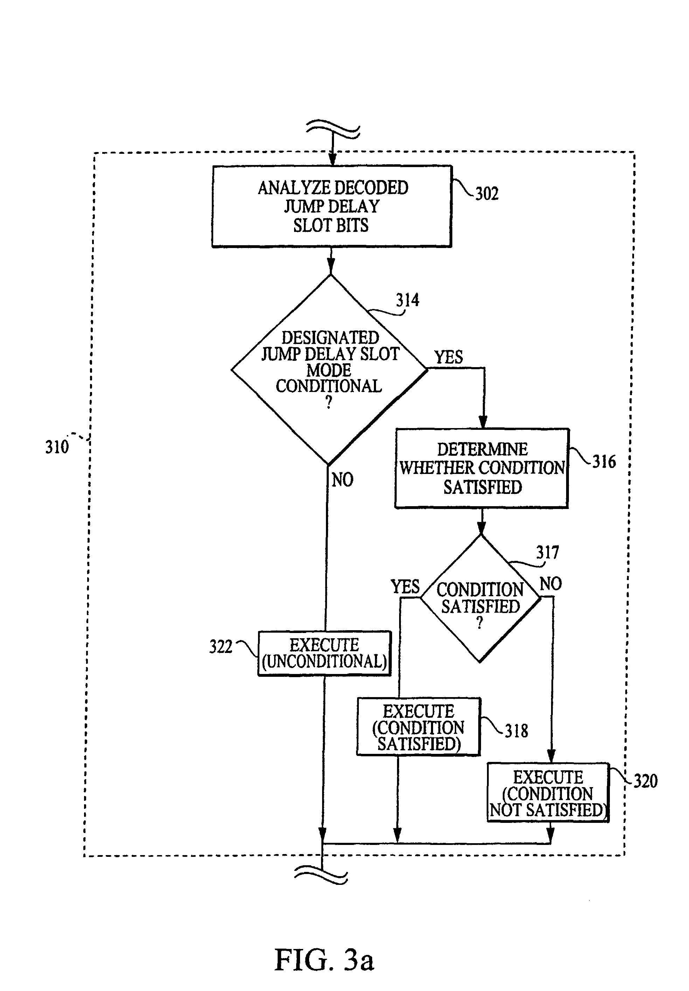

Referring now to Fig. 3, the generalized method 300 of controlling the execution of instructions during jumping within a pipelined processor according to the present invention is described. First, in step 302, a program adapted to run on the processor and comprising a plurality of instruction "words" is provided. Each instruction word in the program is represented by and comprises a plurality of data bits, and at least one of the instruction words comprises a jump instruction. In the present context, the term 'instruction set' is used to describe the complete set of every possible instruction which could be executed on the processor, and the term 'program' is used to describe a specific sequence of instructions selected from the instruction set of the processor to achieve a specific purpose. As used herein, the term "jump" refers to any branch, jump, loop setup, or call instructions, although other instructions requiring a change in the flow of the instruction processing of the processor may conceivably be used in conjunction with the disclosed invention.

Next, in step 304, one of a plurality of predetermined values is assigned to at least one of the data bits of the jump instruction. In one embodiment, two data bits of the jump instruction word are designated to carry the jump delay slot mode information as described below with reference to Table 1. With the allowable binary states of "0" and "1" for each of the two bits, 2² or 4 unique combinations may be formed, each designating a different jump delay slot mode. It will be recognized, however, that any different number of unique (or non-unique) modes may be designated by using more or less data bits, or even a different numerical base employed if desired.

Next, in step 306, the at least one jump instruction containing the jump delay slot mode information is decoded by the processor. Methods and apparatus useful for instruction decoding are well known in the computer arts, and accordingly will not be described further herein. It is noted, however, that in contrast to prior art methods of decoding instructions, decoding of jump instructions within the instruction set of the present invention includes not only decoding of the instruction itself (step 307), but also decoding and analysis of the designated jump delay slot mode data bits (step 308) as previously described.

In step 310, the designated jump delay slot mode is executed, according to the functionality specified by the programmer in step 304.

Fig. 3a illustrates one exemplary embodiment of the method of executing the designated jump delay slot mode per step 310 of Fig. 3. In a first step 312, the data bits designated in step 304 to carry the delay slot mode information are read to determine the jump delay slot mode selected within the instruction being decoded. Next, in step 314, the selected delay slot mode is analyzed to determine if it is conditional (i.e., dependent upon another parameter such as whether or not a jump to another program address is taken). If the selected mode is conditional, the status of the parameter is analyzed in steps 316 and 317 to determine the "truth" thereof. If the condition is true, the required actions for a true condition are executed per step 318. If the condition is not true, the required actions for a false condition are taken (or alternatively no action is taken) per step 320. If the selected mode is not conditional on any parameter, the action required by that mode (such as execution of a subsequent instruction within the pipeline, or a pipeline stall) is executed in step 322.

In one exemplary embodiment of the foregoing method 300, the following three jump modifiers (delay slot modes) are defined:
(1) **ND** ( "No Delayed Instruction Slot") - Only executes the next instruction in pipeline when not jumping; if jumping, one cycle pipeline stall or bubble inserted
(2) **D** ("Delayed Instruction Slot") - Always execute the next instruction regardless of jump status
(3) **JD** ("Jump Delayed Instruction Slot") - Only execute the next instruction when jumping; if not jumping, one cycle pipeline stall or bubble inserted
The first mode (1) provides a pipeline "stall" of one or more cycles in place of an instruction execution if a jump is taken. The second mode (2) provides for execution of a delay slot instruction (i.e., the instruction present in the slot following the jump instruction after decode under all circumstances. The third mode (3) provides for the execution of a delay slot instruction only if a jump is taken. While the following discussion is cast in terms of these three modes, it will be recognized that not all three modes are required to be used collectively or within the same instruction set, and further that other additional delay modes with different functionality may be added to the instruction set to further enhance programming flexibility and control.

The availability of the foregoing three distinct modes provides the programmer with additional flexibility in jump delay slot control, due in part to the ability to customize the instruction set while not being limited to pure multi-cycle or delayed branching approaches as previously described. Specifically, by inserting the appropriate jump delay mode codes within certain instructions within the program, the programmer may obtain beneficial characteristics of both the multi-cycle and delay branching approaches within one processor and one instruction set.

Table 1 illustrates the jump delay mode coding associated with the aforementioned three delay slot modes. In the illustrated embodiment, two binary data bits of the processor instruction word (IW) are used to indicate each one of the three delay slot modes **ND**, **D**, and **JD**:

**Table 1**

| **IW Bits** | **Syntax** | **Mode** |
|---|---|---|
| 00 | .nd | No Delay slot instruction execution if jump taken - one cycle pipeline stall or bubble instead. |
| 01 | .d | Delay slot instruction always executed. |
| 10 | .jd | Delay slot instruction executed only if Jump is taken |
| 11 | | (Reserved) |

Table 2 is a truth table derived from the defined jump delay slot modes of Table 1:

**Table 2**

| | **Condition Truth** | |
|---|---|---|
| **Jump Delay Slot Mode** | **Jump Taken** | **No Jump Taken** |
| .nd | One cycle stall or bubble | Delay slot instruction execution |
| .d | Delay slot instruction execution | Delay slot instruction execution |
| .jd | Delay slot instruction execution | No delay slot instruction execution |

The following assembly language code illustrates examples of the syntax and operation of each of the respective jump delay slot modes of Table 1 using a conditional branch instruction (beq) to program location 'target' followed by a mathematical (add) instruction:

| | | | |
|---|---|---|---|
| (1) | beq.nd | target | ; |
| | add | r1,r1,1 | ; "add" not executed if jump taken |
| (2) | beq.d | target | ; |
| | add | r1,r1,1 | ; "add" always executed |
| (3) | beq.jd | target | : |
| | add | r1,r1,1 | ; "add" executed only if jump taken |

The fourth mode ("11") of Table 1 may be used for other jump mode or non-jump mode functions as desired, thereby affording the programmer even further flexibility Additionally, while two bits of the instruction word are illustrated in the embodiment of Table 1, it will be appreciated that other numbers and arrangements of bits (including their position within the instruction word and their syntax) may conceivably be used. For example, three non-contiguous bits could be used to represent up to eight separate jump delay slot modes.

Table 3 illustrates a second embodiment of the jump delay slot modes of the invention utilizing five jump delay slot modes (four plus one reserved) based on three data bits within the IW:

**Table 3**

| **IW Bits** | **Syntax** | **Mode** |
|---|---|---|
| 000 | | (Reserved) |
| 001 | .jd | Delay slot instruction executed only if Jump is taken |
| 010 | .d | Delay slot instruction always executed. |
| 011 | .ndl | No Delay slot instruction execution if jump taken - one cycle pipeline stall instead. |
| 100 | | (Reserved) |
| 101 | | (Reserved) |
| 110 | | (Reserved) |
| 111 | .nd2 | No Delay slot instruction execution if jump taken - two cycle pipeline stall instead. |

In the illustrated embodiment(s), jump instructions present within the instruction set may stop execution of (i.e. "kill") other instruction types, depending on two factors: (i) the selected delay slot mode, and (ii) whether the jump instruction's condition is true. The following four instructions illustrate the foregoing principles in the context of VHDL coding associated with Applicant's ARC RISC processor:

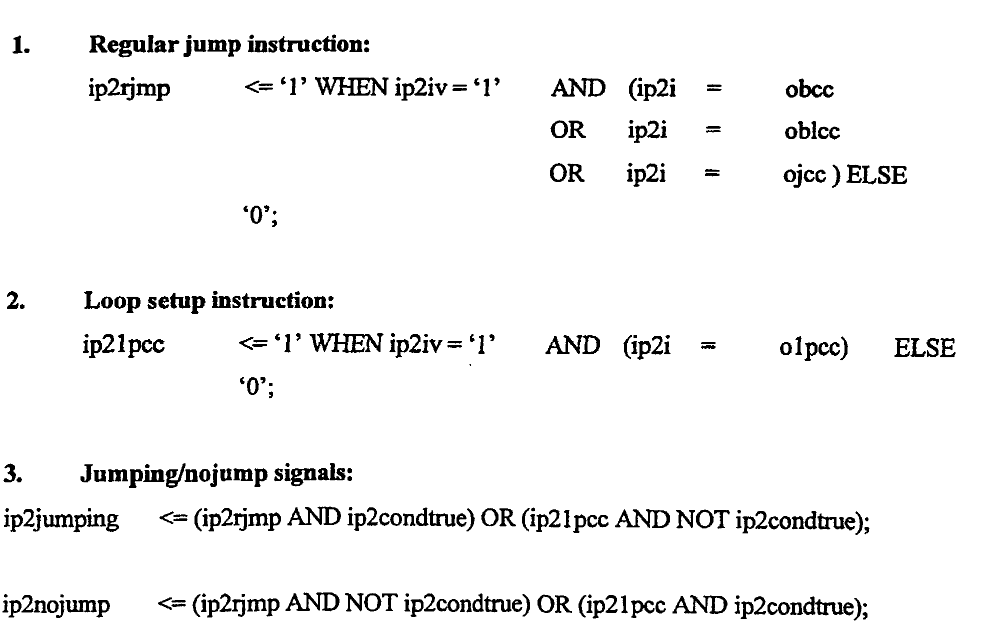

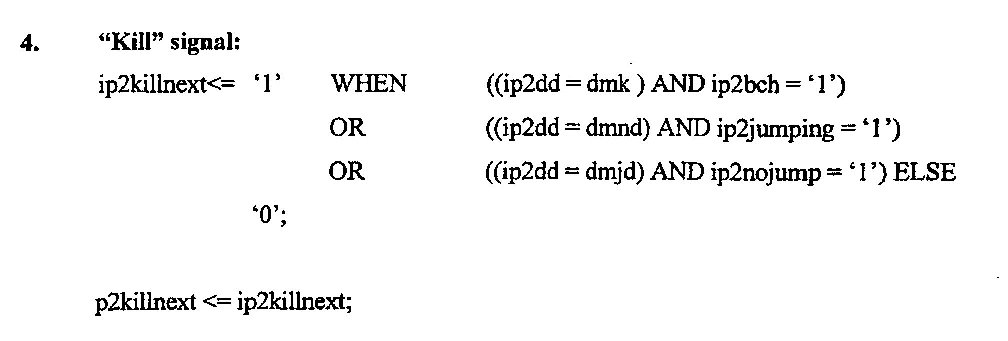

It is noted that the ip2killnext instruction of the illustrated embodiment includes p2iv (pipeline stage 2 instruction valid signal) and a full decode for a jump operation, so that it can be used within the pipeline control logic ("pipectl") without any further decode apart from en2 (pipeline stage 2 enabled/stalled signal). This feature reduces decode delays and permits faster instruction execution. While the decode technique used in this example results in the foregoing operational benefits, it will be recognized that this technique is not essential to the practice of the present invention.

Appendix A illustrates one exemplary embodiment of the VHDL used for synthesis of the foregoing jump delay slot modes of the present invention.

Appendix B provides an exemplary synthesis script for delay slot synthesis using the Synopsys® synthesis engine.

It is also noted that the methods and apparatus of the present invention may be used in conjunction with (either alone or collectively) other methods of pipeline control and interlock including, inter alia, those disclosed in Applicant's co-pending U.S. Patent Application entitled "Method And Apparatus For Jump Control In A Pipelined Processor," as well as those disclosed in Applicant's co-pending U.S. Patent Application entitled "Method And Apparatus For Processor Pipeline Segmentation and Reassembly," both filed contemporaneously herewith. Furthermore, various register encoding schemes, such as the "loose" register encoding described in Applicant's co-pending U.S. Patent Application entitled "Method and Appatatus for Loose Register Encoding Within a Pipelined Processor" filed contemporaneously herewith and incorporated by may be used in conjunction with the jump delay slot invention described herein.

### Method of Synthesizing

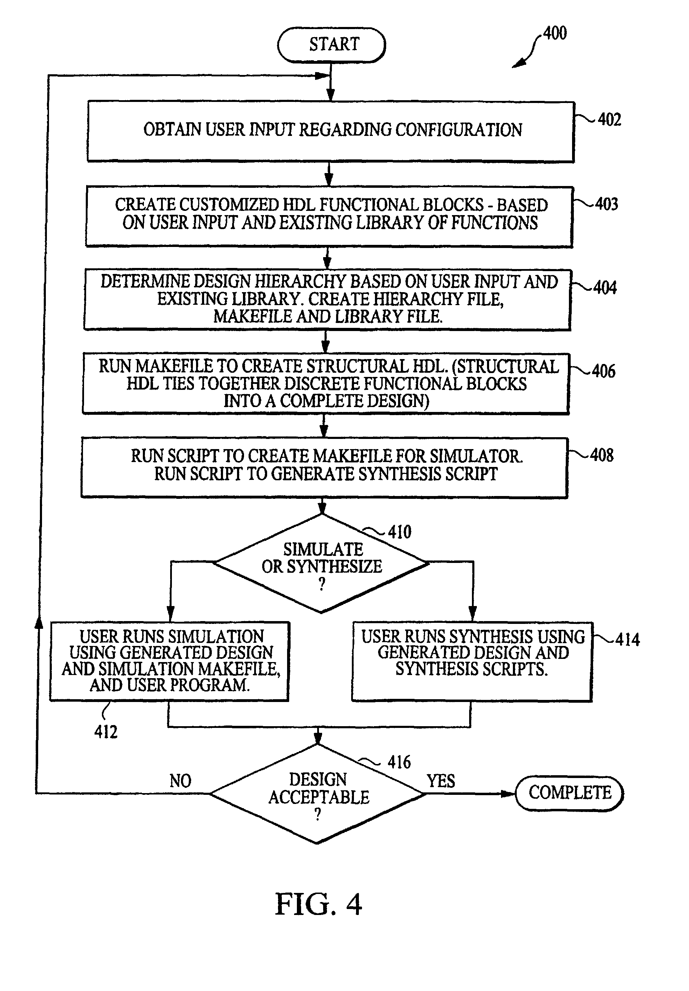

Referring now to Fig. 4, the method 400 of synthesizing logic incorporating the jump delay slot mode functionality previously discussed is described. The generalized method of synthesizing integrated circuit logic having a user-customized (i.e., "soft") instruction set is disclosed in Applicant's co-pending U.S. Patent Application Serial No. 09/418,663 entitled "Method And Apparatus For Managing The Configuration And Functionality Of A Semiconductor Design" filed October 14, 1999.

While the following description is presented in terms of an algorithm or computer program running on a microcomputer or other similar processing device, it can be appreciated that other hardware environments (including minicomputers, workstations, networked computers, "supercomputers", and mainframes) may be used to practice the method. Additionally, one or more portions of the computer program may be embodied in hardware or firmware as opposed to software if desired, such alternate embodiments being well within the skill of the computer artisan.

Initially, user input is obtained regarding the design configuration in the first step 402. Specifically, desired modules or functions for the design are selected by the user, and instructions relating to the design are added, subtracted, or generated as necessary. For example, in signal processing applications, it is often advantageous for CPUs to include a single "multiply and accumulate" (MAC) instruction. In the present invention, the instruction set of the synthesized design is modified so as to incorporate the foregoing jump delay slot modes (or another comparable jump delay slot control architecture) therein . Specifically, in the present embodiment, one of a plurality of predetermined values indicating the designated jump delay slot mode is represented by two data bits of the jump instruction word as described above with reference to Table 1. The technology library location for each VHDL file is also defined by the user in step 402. The technology library files in the present invention store all of the information related to cells necessary for the synthesis process, including for example logical function, input/output timing, and any associated constraints. In the present invention, each user can define his/her own library name and location(s), thereby adding further flexibility.

Next, in step 403, customized HDL functional blocks based on the user's input and the existing library of functions specified in step 402 are created.

In step 404, the design hierarchy is determined based on the user's input and the aforementioned library files. A hierarchy file, new library file, and makefile are subsequently generated based on the design hierarchy. The term "makefile" as used herein refers to the commonly used UNIX makefile function or similar function of a computer system well known to those of skill in the computer programming arts. The makefile function causes other programs or algorithms resident in the computer system to be executed in the specified order. In addition, it further specifies the names or locations of data files and other information necessary to the successful operation of the specified programs. It is noted, however, that the invention disclosed herein may utilize file structures other than the "makefile" type to produce the desired functionality.

In one embodiment of the makefile generation process of the present invention, the user is interactively asked via display prompts to input information relating to the desired design such as the type of "build" (e.g., overall device or system configuration), width of the external memory system data bus, different types of extensions, cache type/size, etc. Many other configurations and sources of input information may be used, however, consistent with the invention.

In step 406, the makefile generated in step 404 is run to create the structural HDL. This structural HDL ties the discrete functional block in the design together so as to make a complete design.

Next, in step 408, the script generated in step 406 is run to create a makefile for the simulator. The script to generate a synthesis script is also run in step 408.

At this point in the program, a decision is made whether to synthesize or simulate the design (step 410). If simulation is chosen, the user runs the simulation using the generated design and simulation makefile (and user program) in step 412. Alternatively, if synthesis is chosen, the user runs the synthesis using the synthesis script(s) and generated design in step 414. After completion of the synthesis/simulation scripts, the adequacy of the design is evaluated in step 416. For example, a synthesis engine may create a specific physical layout of the design that meets the performance criteria of the overall design process yet does not meet the die size requirements. In this case, the designer will make changes to the control files, libraries, or other elements that can affect the die size. The resulting set of design information is then used to re-run the synthesis script.

If the generated design is acceptable, the design process is completed. If the design is not acceptable, the process steps beginning with step 402 are re-performed until an acceptable design is achieved. In this fashion, the method 400 is iterative.

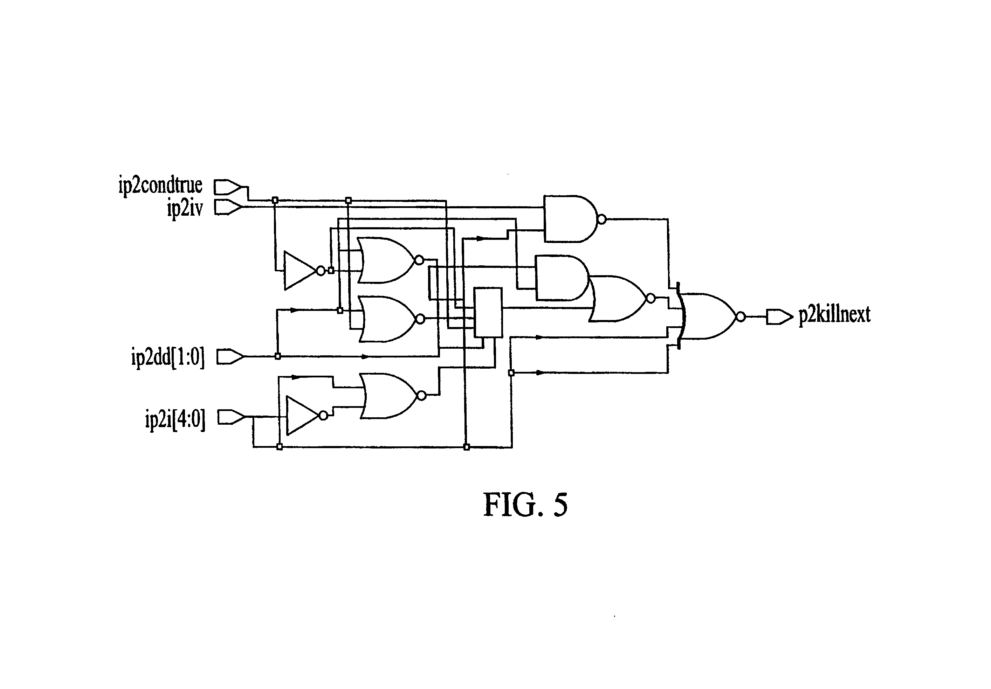

Referring now to Fig. 5, a first embodiment of exemplary gate logic (including the ip2bch signal referenced in the VHDL of Appendix A) synthesized using the aforementioned Synopsys® Design Compiler and methodology of Fig. 4 is illustrated. Note that during the synthesis process used to generate the logic of Fig. 5, an LSI 10k 1.0um process was specified, and no constraints were placed on the design. The p2killnext signal output from the logic of Fig. 5 is used elsewhere in VHDL code (rctl.vhdl) to mark the instruction in stage 1 as "killed" as it passes into stage 2.

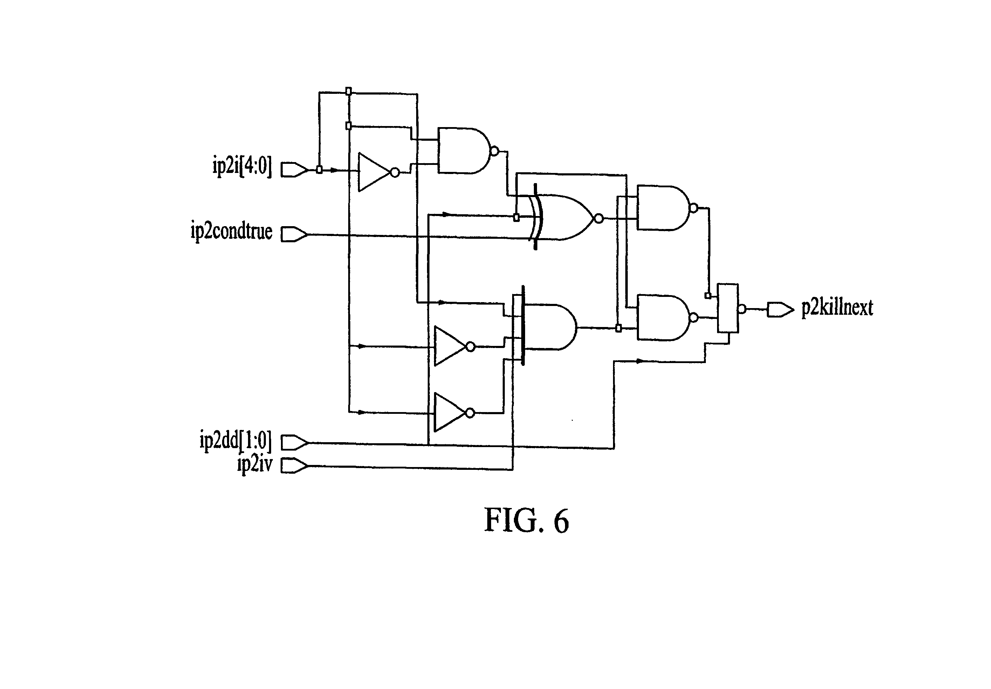

Fig. 6 illustrates a second embodiment of exemplary gate logic synthesized using the Synopsys® Design Compiler and the aforementioned 1.0um process. Unlike the logic of Fig. 5, however, the critical path between ip2condtrue and p2killnext has been constrained to operate in the shortest possible time. As previously noted, a wide variety of other constraints may be applied during synthesis as desired.

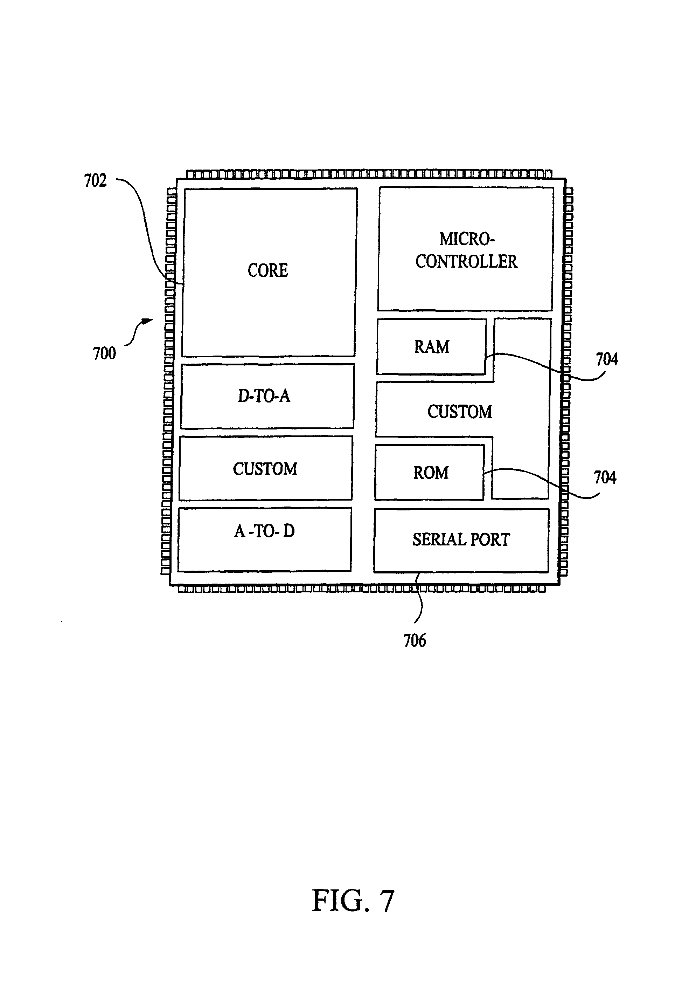

Fig. 7 illustrates an exemplary pipelined processor fabricated using a 1.0 um process and incorporating the logic of Fig. 5 and the jump delay slot modes previously described herein. As shown in Fig. 7, the processor 700 is an ARC microprocessor-like CPU device having, inter alia, a processor core 702, on-chip memory 704, and an external interface 706. The device is fabricated using the customized VHDL design obtained using the method 400 of the present invention, which is subsequently synthesized into a logic level representation, and then reduced to a physical device using compilation, layout and fabrication techniques well known in the semiconductor arts.

It will be appreciated by one skilled in the art that the processor of Fig. 7 may contain any commonly available peripheral such as serial communications devices, parallel ports, timers, counters, high current drivers, analog to digital (A/D) converters, digital to analog converters (D/A), interrupt processors, LCD drivers, memories and other similar devices. Further, the processor may also include custom or application specific circuitry. The present invention is not limited to the type, number or complexity of peripherals and other circuitry that may be combined using the method and apparatus. Rather, any limitations are imposed by the physical capacity of the extant semiconductor processes which improve over time. Therefore it is anticipated that the complexity and degree of integration possible employing the present invention will further increase as semiconductor processes improve.

It is also noted that many IC designs currently use a microprocessor core and a DSP core. The DSP however, might only be required for a limited number of DSP functions, or for the IC's fast DMA architecture. The invention disclosed herein can support many DSP instruction functions, and its fast local RAM system gives immediate access to data. Appreciable cost savings may be realized by using the methods disclosed herein for both the CPU & DSP functions of the IC.

Additionally, it will be noted that the methodology (and associated computer program) as previously described herein can readily be adapted to newer manufacturing technologies, such as 0.18 or 0.1 micron processes, with a comparatively simple re-synthesis instead of the lengthy and expensive process typically required to adapt such technologies using "hard" macro prior art systems.

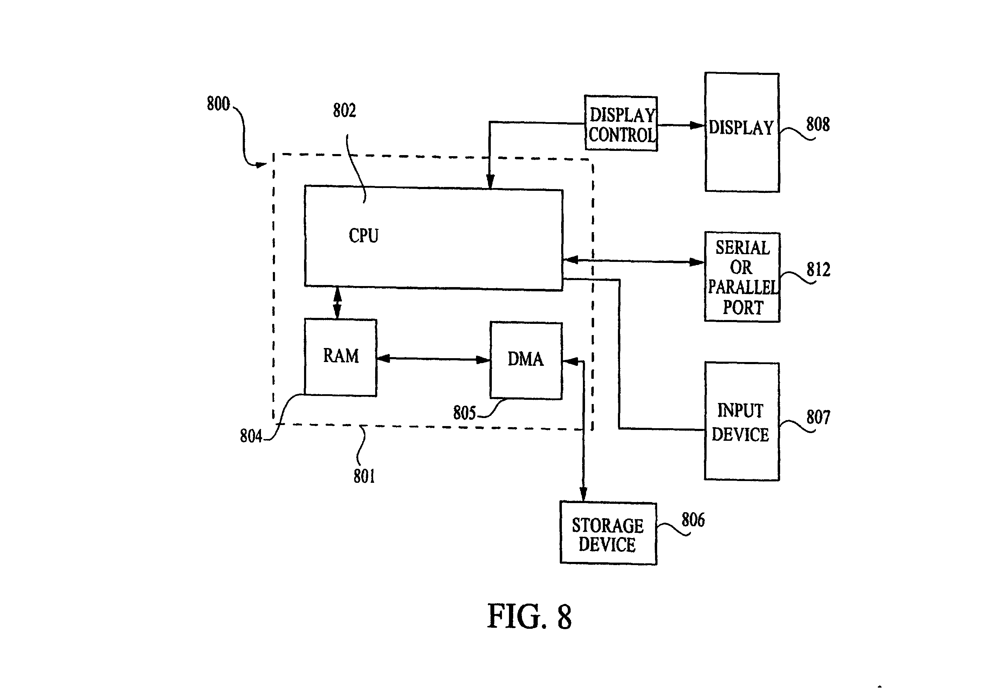

Referring now to Fig. 8, one embodiment of a computing device capable of synthesizing, inter alia, the jump delay mode logic structures of Figs. 5 and 6 herein is described. The computing device 800 comprises a motherboard 801 having a central processing unit (CPU) 802, random access memory (RAM) 804, and memory controller 805. A storage device 806 (such as a hard disk drive or CD-ROM), input device 807 (such as a keyboard or mouse), and display device 808 (such as a CRT, plasma, or TFT display), as well as buses necessary to support the operation of the host and peripheral components, are also provided. The aforementioned VHDL descriptions and synthesis engine are stored in the form of an object code representation of a computer program in the RAM 804 and/or storage device 806 for use by the CPU 802 during design synthesis, the latter being well known in the computing arts. The user (not shown) synthesizes logic designs by inputting design configuration specifications into the synthesis program via the program displays and the input device 807 during system operation. Synthesized designs generated by the program are stored in the storage device 806 for later retrieval, displayed on the graphic display device 808, or output to an external device such as a printer, data storage unit, other peripheral component via a serial or parallel port 812 if desired.

While the above detailed description has shown, described, and pointed out novel features of the invention as applied to various embodiments, it will be understood that various omissions, substitutions, and changes in the form and details of the device or process illustrated may be made by those skilled in the art without departing from the invention. The foregoing description is of the best mode presently contemplated of carrying out the invention. This description is in no way meant to be limiting, but rather should be taken as illustrative of the general principles of the invention. The scope of the invention should be determined with reference to the claims.

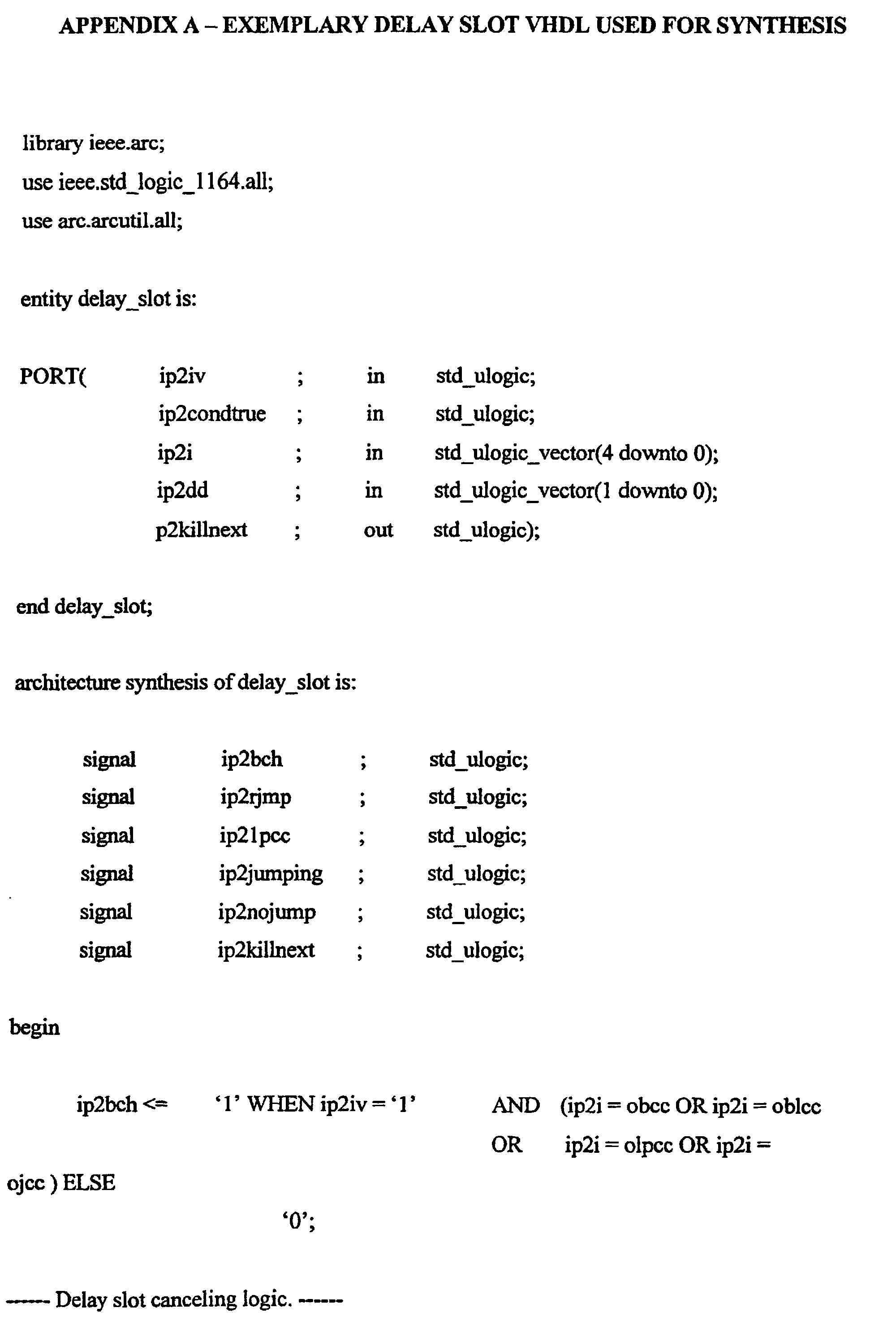

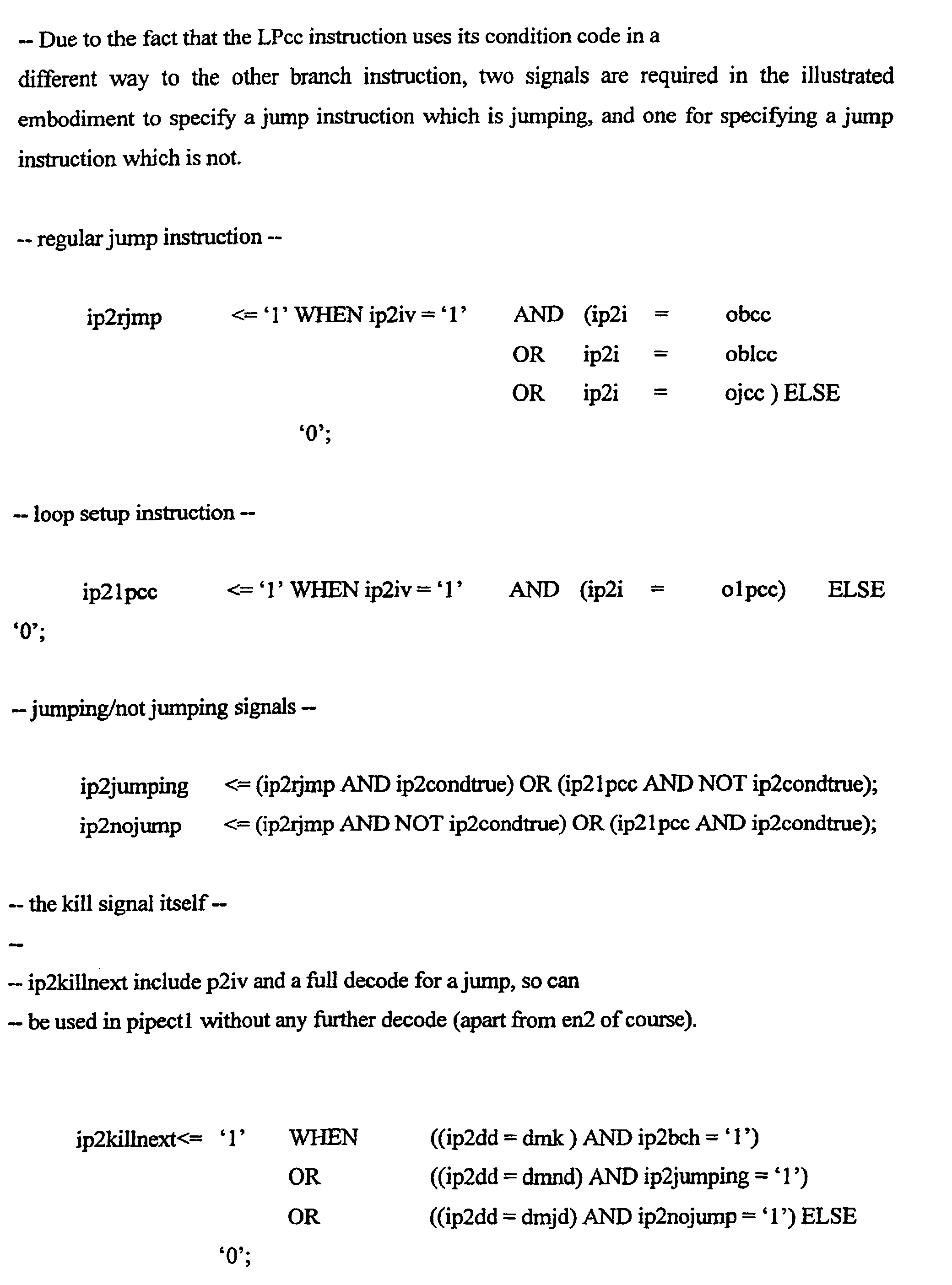

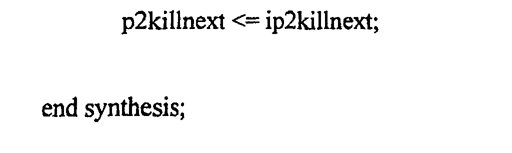

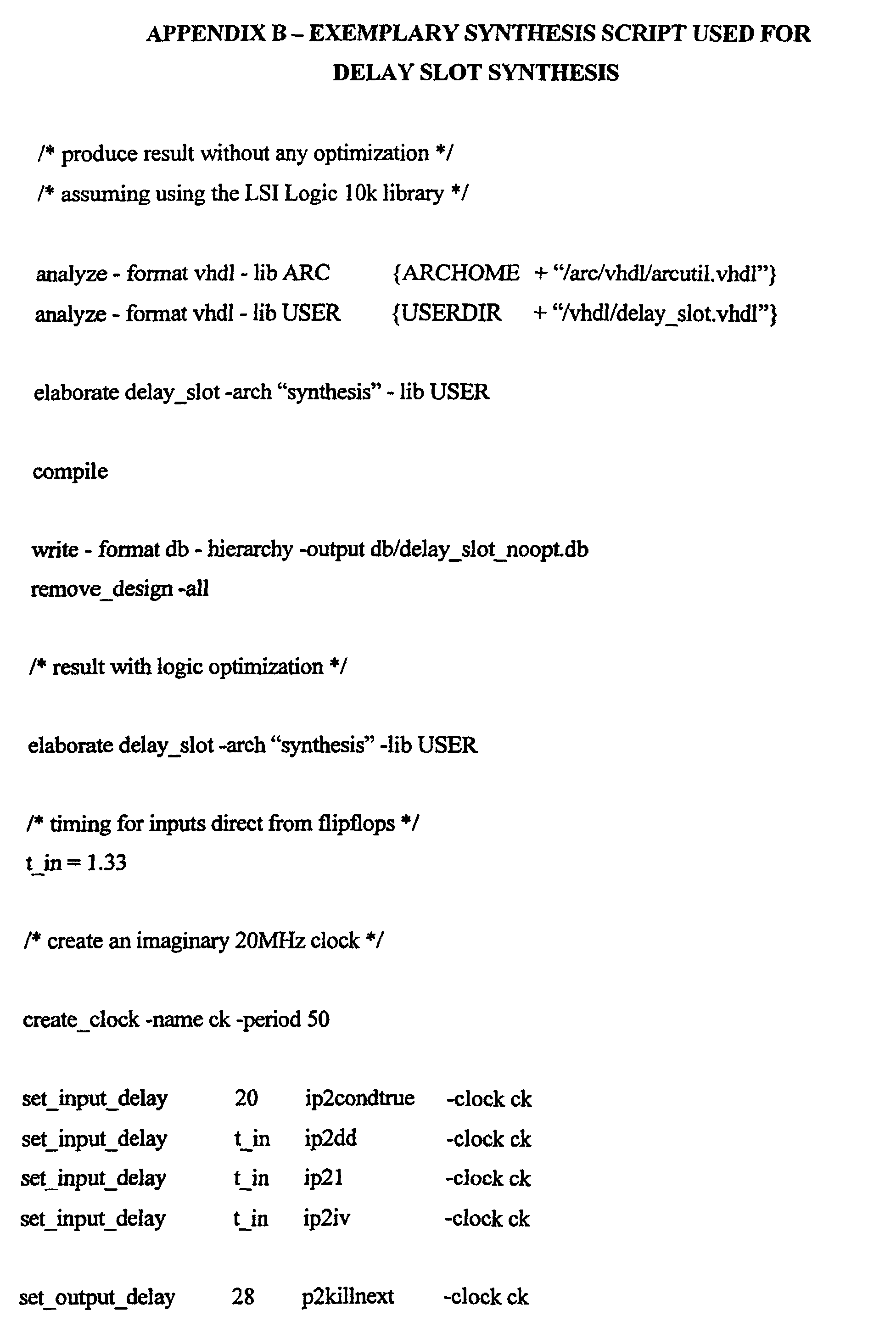

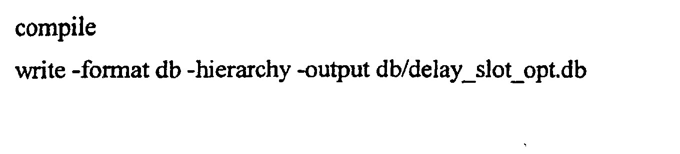

## Claims

1. A method of controlling the execution of instructions within a pipelined processor (700), comprising:
providing an instruction set comprising a plurality of instruction words, each of said instruction words comprising a plurality of data bits, at least one of said words comprising a jump instruction;
assigning one of a plurality of values to a plurality of said data bits of said at least one jump instruction; and
controlling the execution of at least one subsequent instruction within said pipeline based on said one assigned value of said plurality of data bits when said at least one jump instruction is decoded.

2. The method of Claim 1, wherein the act of assigning comprises:
identifying a plurality of data bits within said at least one jump instruction; and
assigning one of two discrete values to each of said data bits, the combination of said two discrete values representing at least three jump delay slot modes within said processor.

3. The method of Claim 2, wherein the act of controlling the execution based on said discrete values comprises selecting at least one mode from the group comprising:
(i) executing said at least one subsequent instruction under all circumstances;
(ii) executing said at least one subsequent instruction only if a jump occurs; and
(iii) stalling the pipeline or inserting a bubble into the pipeline if a jump occurs.

4. The method of Claim 3, wherein said at least one jump instruction comprises a conditional branch instruction.

5. The method of Claim 1, wherein the act of controlling the execution based on said one assigned value comprises:
(i) executing said at least one subsequent instruction under all circumstances;
(ii) executing said at least one subsequent instruction only if a jump occurs; and
(iii) stalling the pipeline or inserting a bubble into the pipeline if a jump occurs.

6. A machine readable data storage device comprising:
a data storage medium adapted to store a plurality of data bits; and
a computer program rendered as a plurality of data bits and stored on said data storage medium, said program being adapted to run on the processor of a computer system and synthesize integrated circuit logic for use in a processor having a pipeline and incorporating an instruction set having at least one branching instruction and a plurality of jump modes defined by a plurality of data bits associated therewith, said plurality of jump modes comprising at least the following:
(i) executing a subsequent instruction within said pipeline under all circumstances;
(ii) executing a subsequent instruction within said pipeline only if jumping occurs; and
(iii) stalling said pipeline if jumping occurs.

7. The data storage device of Claim 6, wherein said data storage medium is a compact disk-read only memory (CD-ROM), and said plurality of data bits comprises an object representation of said program.

8. A digital processor (700) comprising:
(i) a processor core having a multistage instruction pipeline, said core being adapted to decode and execute an instruction set comprising a plurality of instruction words;
(ii) a data interface between said processor core (702) and an information storage device; and
an instruction set comprising a plurality of instruction words, at least one of said instruction words being a jump instruction containing data defining a plurality of jump delay slot modes, said plurality of modes controlling the execution of instructions within said instruction pipeline of said processor core in response to said at least one jump instruction word within said instruction set.

9. The processor of Claim 8, wherein said plurality of jump delay slot modes comprises at least the following modes:
(i) executing a subsequent instruction within said pipeline under all circumstances;
(ii) executing a subsequent instruction within said pipeline only if jumping occurs; and
(iii) stalling the pipeline if jumping occurs.

10. The processor of Claim 8, wherein said at least one jump instruction comprises a conditional branch instruction having an associated logical condition, the execution of a jump to the address within said information storage device specified by said at least one conditional branch instruction being determined by said logical condition.

11. The method of Claim 5, wherein said data bits comprise binary (base 2) data.

12. A method of controlling the branching within the program of a multi-stage pipelined digital processor (700), comprising:
storing an instruction set within said data storage device (704, 706), said instruction set comprising a plurality of instruction words, each of said instruction words comprising a plurality of data bits, at least one of said instruction words comprising a branch instntction directing branching to a first address within said data storage device based on a first parameter;
defining a plurality of jump modes;
assigning said plurality of distinct jump modes to respective combinations of said data bits of said at least one branch instruction;
decoding said at least one branch instruction including said plurality of data bits; and
determining whether to branch to said first address based on said data bits and said first parameter.

13. The method of Claim 12, wherein the act of defining a plurality of jump modes comprises defining the following modes:
(i) executing a subsequent instruction under all circumstances;
(ii) executing a subsequent instruction only if jumping occurs; and
(iii) stalling the pipeline or inserting a bubble into the pipeline if jumping occurs.

14. The digital processor of Claim 8, wherein the act of defining a plurality of jump delay slot modes comprises:
identifying a plurality of data bits within said at least one jump instruction; and
assigning one of two discrete values to each of said data bits, the combination of said two discrete values representing at least three jump delay slot modes within said processor.

15. The digital processor of Claim 14, wherein the act of controlling the execution comprises selecting at least one delay slot mode from the group comprising:
(i) executing said at least one subsequent instruction under all circumstances;
(ii) executing said at least one subsequent instruction only if a jump occurs; and
(iii) stalling the pipeline or inserting a bubble into the pipeline if a jump occurs.

16. The digital processor of Claim 8, wherein said multistage instruction pipeline comprises at least fetch, decode, execute, and writeback stages, and said processor further comprises logic controlled at least in part by said jump delay slot modes, said logic being adapted to identify before decoding thereof those instructions that are not to be executed by said processor.

17. The digital processor of Claim 16, wherein said logic is configured such that the critical path between the input and output of said logic is constrained to operate in the shortest possible time.

18. The digital processor of Claim 8, wherein said processor comprises a user-customizable RISC processor having an extension instruction set.

19. The digital processor of Claim 8, wherein said jump delay slot modes are defined by a plurality of data bits resident within said jump instruction.

20. The digital processor of Claim 19, wherein said plurality of data bits comprises three contiguous data bits having binary (base 2) data.

21. The digital signal processor of Claim 19, wherein said act of controlling the execution of instructions within said instruction pipeline comprises:
determining whether the jump delay slot mode of said jump instruction is conditional;
determining the value of the parameter(s) upon which such jump mode is conditional; and
determining whether to execute said instructions within said pipeline based at least in part on said value of said parameter.

22. The method of Claim 1, further comprising:
decoding said jump instruction in the decode stage of the pipeline of said processor;
decoding said plurality of data bits in said decode stage to identify one of a plurality of jump modes associated with said jump instruction;
determining whether said jump mode is conditional;
determining the value of the parameter(s) upon which such jump mode is conditional; and
determining whether to execute said instructions within said pipeline based at least in part on said value of said parameter.

23. The method of Claim 22, further comprising identifying, before decoding thereof, those instructions fetched into said pipeline that are not to be executed by said processor.

## Patentansprüche

1. Verfahren zum Steuern der Ausführung von Befehlen in einem Fließbandprozessor (700), das folgendes aufweist:
Vorsehen eines Befehlssatzes, der eine Vielzahl von Befehlswörtern aufweist, wobei jedes der Befehlswörter eine Vielzahl von Datenbits aufweist, wobei mindestens eines der Wörter einen Sprungbefehl aufweist;
Zuordnen eines von einer Vielzahl von Werten zu einer Vielzahl der Datenbits des mindestens einen Sprungbefehls; und
Steuern der Ausführung von mindestens einem nachfolgenden Befehl innerhalb des Fließbands auf der Basis des einen zugeordneten Werts der Vielzahl von Datenbits, wenn der mindestens eine Sprungbefehl decodiert wird.

2. Verfahren nach Anspruch 1, wobei der Schritt des Zuordnens folgendes aufweist:
Erkennen einer Vielzahl von Datenbits in dem mindestens einen Sprungbefehl; und
Zuordnen von zwei diskreten Werten zu jedem der Datenbits, wobei die Kombination der zwei diskreten Werte mindestens drei Sprungverzögerungs-Zeitschlitzmoden in dem Prozessor repräsentiert.

3. Verfahren nach Anspruch 2, wobei der Schritt des Steuerns der Ausführung auf der Basis der diskreten Werte aufweist: Auswählen von mindestens einem Modus aus der Gruppe, die folgendes aufweist:
(i) Ausführens des mindestens einen nachfolgenden Befehls unter allen Umständen;
(ii) Ausführen des mindestens einen nachfolgenden Befehls nur dann, wenn ein Sprung erfolgt; und
(iii) Verzögern des Fließbands oder Einfügen einer Blase in das Fließband, wenn ein Sprung erfolgt.

4. Verfahren nach Anspruch 3, wobei der mindestens eine Sprungbefehl einen bedingten Sprungbefehl aufweist.

5. Verfahren nach Anspruch 1, wobei der Schritt des Steuerns der Ausführung auf der Basis des einen zugeordneten Werts folgendes aufweist:
(i) Ausführen des mindestens einen nachfolgenden Befehls unter allen Umständen;
(ii) Ausführen des mindestens einen nachfolgenden Befehls nur dann, wenn ein Sprung erfolgt; und
(iii) Verzögern des Fließbands oder Einfügen einer Blase in das Fließband, wenn ein Sprung erfolgt.

6. Maschinenlesbare Datenspeichervorrichtung, der folgendes aufweist:
ein Datenspeichermedium, das so ausgebildet ist, daß es eine Vielzahl von Datenbits speichert; und
ein Computerprogramm, das als eine Vielzahl von Datenbits ausgeführt und auf dem Datenspeichermedium gespeichert ist, wobei das Programm so ausgebildet ist, daß es auf dem Prozessor eines Computersystems abläuft und eine integrierte Schaltungslogik zur Verwendung in einem Prozessor synthetisiert, der ein Fließband hat und einen Befehlssatz aufweist, der mindestens einen Sprungbefehl und eine Vielzahl von Sprungmoden hat, die durch eine Vielzahl von zugeordneten Datenbits definiert sind, wobei die Vielzahl von Sprungmoden mindestens folgendes aufweist:
(i) Ausführen eines nachfolgenden Befehls innerhalb des Fließbands unter allen Umständen;
(ii) Ausführen eines nachfolgenden Befehls innerhalb des Fließbands nur dann, wenn ein Sprung erfolgt;
(iii) Verzögern des Fließbands, wenn ein Sprung erfolgt.

7. Datenspeichervorrichtung nach Anspruch 6, wobei das Datenspeichermedium ein CD-Festwertspeicher (CD-ROM) ist, und die Vielzahl von Datenbits eine Objektdarstellung des Programms aufweist.

8. Digitalprozessor (700), der folgendes aufweist:
(i) einen Prozessorkern, der ein Mehrstufen-Befehlsfließband hat, wobei der Kern so ausgebildet ist, daß er einen Befehlssatz decodiert und ausführt, der eine Vielzahl von Befehlswörtern aufweist;
(ii) eine Datenschnittstelle zwischen dem Prozessorkern (702) und einer Informationsspeichervorrichtung; und
einen Befehlssatz, der eine Vielzahl von Befehlswörtern aufweist, wobei mindestens eines der Befehlswörter ein Sprungbefehl ist, der Daten enthält, die eine Vielzahl von Sprungverzögerungs-Zeitschlitzmoden definieren, wobei die Vielzahl von Moden die Ausführung von Befehlen innerhalb des Befehlsfließbands des Prozessorkerns in Abhängigkeit von dem mindestens einen Sprungbefehlswort innerhalb des Befehlssatzes steuert.

9. Prozessor nach Anspruch 8, wobei die Vielzahl von Sprungverzögerungs-Zeitschlitzmoden mindestens die folgenden Moden aufweist:
(i) Ausführen eines nachfolgenden Befehls innerhalb des Fließbands unter allen Umständen;
(ii) Ausführen eines nachfolgenden Befehls innerhalb des Fließbands nur dann, wenn ein Sprung erfolgt; und
(iii) Verzögern des Fließbands, wenn ein Sprung erfolgt.

10. Prozessor nach Anspruch 8, wobei der mindestens eine Sprungbefehl einen bedingten Sprungbefehl aufweist, der eine zugeordnete logische Bedingung hat, wobei die Ausführung eines Sprungs zu der Adresse innerhalb der Informationsspeichervorrichtung, die durch den mindestens einen bedingten Sprungbefehl spezifiziert ist, durch die logische Bedingung bestimmt ist.

11. Verfahren nach Anspruch 5, wobei die Datenbits Binärdaten (Basis-2-Daten aufweisen.

12. Verfahren zum Steuern der Verzweigung innerhalb des Programms eines Mehrstufen-Fließband-Digitalprozessor (700), das folgendes aufweist:
Speichern eines Befehlssatzes in der Datenspeichervorrichtung (704, 706), wobei der Befehlssatz eine Vielzahl von Befehlswörtern aufweist, wobei jedes der Befehlswörter eine Vielzahl von Datenbits aufweist, wobei mindestens eines der Befehlswörter einen Sprungbefehl aufweist, der den Sprung zu einer ersten Adresse in der Datenspeichervorrichtung auf der Basis eines ersten Parameters leitet;
Definieren einer Vielzahl von Sprungmoden;
Zuordnen der Vielzahl von einzelnen Sprungmoden zu jeweiligen Kombinationen der Datenbits des mindestens einen Sprungbefehls;
Decodieren des mindestens einen Sprungbefehls einschließlich der Vielzahl von Datenbits; und
Bestimmen auf der Basis der Datenbits und des ersten Parameters, ob ein Sprung zu der ersten Adresse erfolgen soll.

13. Verfahren nach Anspruch 12, wobei der Schritt des Definierens einer Vielzahl von Sprungmoden das Definieren der folgenden Moden aufweist:
(i) Ausführen eines nachfolgenden Befehls unter allen Umständen;
(ii) Ausführen eines nachfolgenden Befehls nur dann, wenn ein Sprung erfolgt; und
(iii) Verzögern des Fließbands oder Einfügen einer Blase in das Fließband, wenn ein Sprung erfolgt.

14. Digitalprozessor nach Anspruch 8, wobei der Schritt des Definierens einer Vielzahl von Sprungverzögerungs-Zeitschlitzmoden folgendes aufweist:
Erkennen einer Vielzahl von Datenbits innerhalb des mindestens einen Sprungbefehls; und
Zuordnen eines von zwei diskreten Werten zu jedem der Datenbits, wobei die Kombination der zwei diskreten Werte mindestens drei Sprungverzögerungs-Zeitschlitzmoden in dem Prozessor repräsentiert.

15. Digitalprozessor nach Anspruch 14, wobei der Schritt des Steuerns der Ausführung aufweist: Auswählen von mindestens einem Verzögerungs-Zeitschlitzmodus aus der Gruppe, die folgendes aufweist:
(i) Ausführen des mindestens einen nachfolgenden Befehls unter allen Umständen;
(ii) Ausführen des mindestens einen nachfolgenden Befehls nur dann, wenn ein Sprung erfolgt; und
(iii) Verzögern des Fließbands oder Einfügen einer Blase in das Fließband, wenn ein Sprung erfolgt.

16. Digitalprozessor nach Anspruch 8, wobei das Mehrstufen-Befehlsfließband mindestens Abruf-, Decodier-, Ausführungs- und Writebackstufen aufweist, und der Prozessor ferner eine Logik aufweist, die mindestens teilweise durch die Sprungverzögerungs-Zeitschlitzmoden gesteuert wird, wobei die Logik so ausgebildet ist, daß sie diejenigen Befehle, die von dem Prozessor nicht auszuführen sind, erkennt, bevor sie decodiert werden.

17. Digitalprozessor nach Anspruch 16, wobei die Logik so ausgebildet ist, daß der kritische Pfad zwischen dem Eingang und dem Ausgang der Logik gezwungen wird, innerhalb der kürzestmöglichen Zeit wirksam sein.

18. Digitalprozessor nach Anspruch 8, wobei der Prozessor einen benutzerspezifisch anpaßbaren RISC-Prozessor aufweist, der einen Erweiterungsbefehlssatz hat.

19. Digitalprozessor nach Anspruch 8, wobei die Sprungverzögerungs-Zeitschlitzmoden von einer Vielzahl von Datenbits definiert sind, die innerhalb des Sprungbefehls resident sind.

20. Digitalprozessor nach Anspruch 19, wobei die Vielzahl von Datenbits drei benachbarte Datenbits aufweist, die Binärdaten (Basis-2-Daten) haben.

21. Digitalsignalprozessor nach Anspruch 19, wobei der Schritt des Steuerns der Ausführung von Befehlen innerhalb des Befehlsfließbands folgendes aufweist:
Bestimmen, ob der Sprungverzögerungs-Zeitschlitzmodus des Sprungbefehls bedingt ist;
Bestimmen des Werts des (der) Parameter, aufgrund dessen ein solcher Sprungmodus bedingt ist; und
Bestimmen, ob die Befehle innerhalb des Fließbands mindestens teilweise auf der Basis des Werts des Parameters auszuführen sind.

22. Verfahren nach Anspruch 1, das ferner folgendes aufweist:
Decodieren des Sprungbefehls in der Decodierstufe des Fließbands des Prozessors;
Decodieren der Vielzahl von Datenbits in der Decodierstufe, um einen von einer Vielzahl von Sprungmoden zu erkennen, die dem Sprungbefehl zugeordnet sind;
Bestimmen, ob der Sprungmodus bedingt ist;
Bestimmen des Werts des (der) Parameter, aufgrund dessen ein solcher Sprungmodus bedingt ist; und
Bestimmen, ob die Befehle innerhalb des Fließbands mindestens teilweise auf der Basis des Werts des Parameters auszuführen sind.

23. Verfahren nach Anspruch 22, das ferner folgendes aufweist: Erkennen derjenigen in das Fließband abgerufenen Befehle, die von dem Prozessor nicht auszuführen sind, bevor sie decodiert werden.

## Revendications

1. Procédé de contrôle de l'exécution d'instructions dans un processeur à pipe-line (700), comprenant les étapes consistant à :
- fournir un jeu d'instructions comprenant une pluralité de mots d'instructions, chacun desdits mots d'instructions comprenant une pluralité de bits de données, au moins un desdits mots comprenant une instruction de saut ;
- attribuer une valeur parmi une pluralité de valeurs à une pluralité desdits bits de données de ladite au moins une instruction de saut ; et
- contrôler l'exécution d'au moins une instruction ultérieure dans ledit pipe-line basée sur ladite valeur attribuée de ladite pluralité de bits de données lorsque ladite au moins une instruction de saut est décodée.

2. Procédé selon la revendication 1, dans lequel l'acte d'attribution comprend :
- une identification d'une pluralité de bits de données dans ladite au moins une instruction de saut ; et
- une attribution d'une valeur parmi deux valeurs discrètes à chacun desdits bits de données, la combinaison desdites deux valeurs discrètes représentant au moins trois modes d'intervalles de retard de saut dans ledit processeur.

3. procédé selon la revendication 2, dans lequel l'acte de contrôle de l'exécution basée sur lesdites valeurs discrètes comprend une sélection d'au moins un mode à partir du groupe comprenant :
(i) une exécution de ladite au moins une instruction ultérieure dans toutes les circonstances ;
(ii) une exécution de ladite au moins une instruction ultérieure seulement si un saut a lieu ; et
(iii) un blocage du pipe-line ou une insertion d'une bulle dans le pipe-line si un saut a lieu.

4. Procédé selon la revendication 3, dans lequel ladite au moins instruction de saut comprend une instruction de branchement conditionnelle.

5. Procédé selon la revendication 1, dans lequel l'acte de contrôle de l'exécution basée sur ladite valeur attribuée comprend :
(i) une exécution de ladite au moins une instruction ultérieure dans toutes les circonstances ;
(ii) une exécution de ladite au moins une instruction ultérieure seulement si un saut a lieu ; et
(iii) un blocage du pipe-line ou une insertion d'une bulle dans le pipe-line si un saut apparaît.

6. Dispositif de stockage de données lisibles sur machine comprenant :
- un milieu de stockage de données adapté pour stocker une pluralité de bits de données ; et
- un programme d'ordinateur rendu sous forme d'une pluralité de bits de données et stocké sur ledit milieu de stockage de données, ledit programme étant adapté pour s'exécuter sur le processeur d'un système d'ordinateur et une logique de circuit intégré de synthèse pour utilisation dans un processeur ayant un pipe-line et incorporant un jeu d'instructions ayant au moins une instruction de branchement et une pluralité de modes de saut définis par une pluralité de bits de données associés, ladite pluralité de modes de saut comprenant au moins ce qui suit :
(i) exécuter une instruction ultérieure dans ledit pipe-line dans toutes les circonstances ;
(ii) exécuter une instruction ultérieure dans ledit pipe-line seulement si un saut a lieu ;
(iii) bloquer ledit pipe-line si un saut a lieu.

7. Dispositif de stockage de données selon la revendication 6, dans lequel ledit milieu de stockage de données est une mémoire morte de disque compact (CD-ROM) et ladite pluralité de bits de données comprend une représentation d'objets dudit programme.

8. Processeur numérique (700) comprenant :
(i) un noyau de processeur ayant un pipe-line d'instructions à plusieurs phases, ledit noyau étant adapté pour décoder et exécuter un jeu d'instructions comprenant une pluralité de mots d'instructions ;
(ii) une interface de données entre ledit noyau de processeur (702) et un dispositif de stockage d'informations ; et
un jeu d'instructions comprenant une pluralité de mots d'instructions, au moins un desdits mots d'instructions étant une instruction de saut contenant des données définissant une pluralité de modes d'intervalles de retard de saut, ladite pluralité de modes contrôlant l'exécution des instructions dans ledit pipe-line d'instructions dudit noyau de processeur en réponse audit au moins un mot d'instructions de saut dans ledit jeu d'instructions.

9. Processeur selon la revendication B, dans lequel ladite pluralité de modes d'intervalles de retard de saut comprend au moins les modes suivants :
(i) exécuter une instruction ultérieure dans ledit pipe-line dans toutes les circonstances ;
(ii) exécuter une instruction ultérieure dans ledit pipe-line seulement si un saut a lieu ; et
(iii) bloquer le pipe-line si un saut a lieu.

10. Processeur selon la revendication 8, dans lequel ladite au moins une instruction de saut comprend une instruction de branchement conditionnelle ayant une condition logique associée, l'exécution d'un saut dans ledit dispositif de stockage d'informations à l'adresse spécifiée par ladite au moins une instruction de branchement conditionnelle étant déterminée par ladite condition logique.

11. Procédé selon la revendication 5, dans lequel lesdits bits de données comprennent des données binaires (base 2).

12. Procédé de contrôle du branchement dans le programme d'un processeur numérique à pipe-line à plusieurs phases (700), comprenant les étapes consistant à :
- stocker un jeu d'instructions dans ledit dispositif de stockage (704, 706), ledit jeu d'instructions comprenant une pluralité de mots d'instructions, chacun desdits mots d'instructions comprenant une pluralité de bits de données, au moins un desdits mots d'instructions comprenant une instruction de branchement dirigeant le branchement à une première adresse dans ledit dispositif de stockage de données basé sur un premier paramètre ;
- définir une pluralité de modes de saut ;
- attribuer ladite pluralité de modes de saut distincts aux combinaisons respectives desdits bits de données de ladite au moins une instruction de branchement ;
- décoder ladite au moins une instruction de branchement comprenant ladite pluralité de bits de données ; et
- déterminer si le branchement à ladite première adresse basée sur lesdits bits de données et ledit premier paramètre est effectué.

13. Procédé selon la revendication 12, dans lequel l'acte de définir une pluralité de modes de sauts comprend de définir les modes suivants :
(i) exécuter une instruction ultérieure dans toutes les circonstances ;
(ii) exécuter une instruction ultérieure seulement si un saut a lieu ; et
(iii) bloquer le pipe-line ou insérer une bulle dans le pipeline si un saut a lieu.

14. Processeur numérique selon la revendication 8, dans lequel l'acte de définir une pluralité de modes d'intervalles de retard de saut comprend :
une identification d'une pluralité de bits de données dans ladite au moins une instruction de sauts ; et
une attribution d'une valeur parmi deux valeurs discrètes à chacun desdits bits de données, la combinaison desdites deux valeurs discrètes représentant au moins trois modes d'intervalles de retard de saut dans ledit processeur.

15. Processeur numérique selon la revendication 14, dans lequel l'acte de contrôler l'exécution comprend la sélection d'au moins un mode d'intervalle de retard à partir du groupe comprenant :
(i) une exécution de ladite au moins une instruction ultérieure dans toutes les circonstances ;
(ii) une exécution de ladite au moins une instruction ultérieure seulement si un saut a lieu ; et
(iii) un blocage du pipe-line ou une insertion d'une bulle dans le pipe-line si un saut a lieu.

16. Processeur numérique selon la revendication 8, dans lequel ledit pipe-line d'instructions à plusieurs phases comprend au moins les phases d'extraction, de décodage, d'exécution, et d'écriture de retour, et ledit processeur comprend en outre une logique contrôlée au moins en partie par lesdits modes d'intervalles de retard de saut, ladite logique étant adaptée pour identifier avant décodage ces instructions qui ne doivent pas être exécutées par ledit processeur.

17. processeur numérique selon la revendication 16, dans lequel ladite logique est configurée de telle sorte que le chemin critique entre l'entrée et la sortie de ladite logique est contraint de s'opérer dans le temps le plus court possible.

18. Processeur numérique selon la revendication 8, dans lequel ledit processeur comprend un processeur RISC personnalisable à l'utilisateur et ayant un jeu d'instructions d'extension.

19. Processeur numérique selon la revendication 8, dans lequel lesdits modes d'intervalles de retard de saut sont définis par une pluralité de bits de données résidant dans ladite instruction de saut.

20. Processeur numérique selon la revendication 19, dans lequel ladite pluralité de bits de données comprend trois bits de données contigus ayant des données binaires (base 2).

21. Processeur de signal numérique selon la revendication 19, dans lequel ledit acte de contrôle de l'exécution des instructions dans ledit pipe-line d'instructions comprend :
- de déterminer si le mode d'intervalles de retard de sauts de ladite instruction de saut est conditionnel ;
- de déterminer la valeur du(des) paramètre(s) sur lequel (lesquels) un tel mode de saut est conditionnel ; et
- de déterminer si l'exécution desdites instructions dans ledit pipe-line basé au moins en partie sur ladite valeur dudit paramètre doit être effectuée.

22. Procédé selon la revendication 1, comprenant en outre les étapes consistant à :
- décoder ladite instruction de saut dans la phase de décodage du pipe-line dudit processeur ;
- décoder ladite pluralité de bits de données dans ladite phase de décodage pour identifier un mode parmi une pluralité de modes de saut associé à ladite instruction de saut ;
- déterminer si ledit mode de saut est conditionnel ;
- déterminer la valeur du(des) paramètre(s) sur lequel (lesquels) un tel mode de saut est conditionnel ; et
- déterminer si l'exécution desdites instructions dans ledit pipe-line basé au moins en partie sur ladite valeur dudit paramètre doit être effectuée.

23. Procédé selon la revendication 22, comprenant en outre l'étape consistant à identifier, avant de décoder, ses instructions extraites dudit pipe-line qui ne doivent pas être exécutées par ledit processeur.
